# EUROPÄISCHE PATENTANMELDUNG

(11) **EP 1 275 972 A2**
(43) Veröffentlichungstag der Anmeldung: **15.01.2003**
(21) Anmeldenummer: 02100803.2
(22) Anmeldetag: 12.07.2002
(51) Int. Cl.: G01R 33/34

(54) **Hochfrequenz-Spulenanordnung für ein MR-Gerät**

(30) Priorität: 13.07.2001 DE 10134171
(71) Anmelder: Philips Corporate Intellectual Property GmbH, 20099 Hamburg (DE); Koninklijke Philips Electronics N.V., 5621 BA Eindhoven (NL)
(72) Erfinder: Leussler, Christoph, 52066 Aachen (DE)
(74) Vertreter: Volmer, Georg, Dipl.-Ing.

(57) **Zusammenfassung**

Die Erfindung betrifft eine Hochfrequenz-Spulenanordnung für ein offenes MR-Gerät. Die Anordnung besteht aus einer Mehrzahl von Resonatorelementen, die im Bereich eines im Untersuchungsvolumen eines MR-Gerätes befindlichen Patienten (102) angsordnet werden. Die Resonatorelemente sind zumindest teilweise als Solenoidelemente (104) ausgebildet, deren Leiterelemente um den Patienten (102) herum geführte, offene Windungen bilden. Dadurch wird erreicht, dass das im Sendebetrieb erzeugte Hochfrequenzfeld und ebenso das bei der Detektion relevante räumliche Empfindlichkeitsprofil möglichst eng auf das interessierende Untersuchungsvolumen beschränkt sind Gleichzeitig können für die Anforderungen der medizinischen Bildgebung ausreichende Hochfrequenz-Feldstärken bei vertretbarer Belastung für den Patienten (102) erzeugt werden.

## Beschreibung

Die Erfindung betrifft eine Hochfrequenz-Spulenanordnung, für ein offenes MR-Gerät, mit einer Mehrzahl von Resonatorelementen, die im Bereich eines im Untersuchungsvolumen eines MR-Gerätes befindlichen Patienten angeordnet werden, wobei die Resonatorelemente aus wenigstens einem Leiterelement und wenigstens einem Kondensator bestehen.

Bei der MR-Bildgebung erfolgt die Lokalisierung der Kernmagnetisierung innerhalb des Untersuchungsvolumens mittels zeitlich veränderlicher räumlich inhomogener Magnetfelder (Magnetfeldgradienten), die einem statischen, möglichst homogenen Magnetfeld überlagert sind. Zur Bilderzeugung wird das Kernspinsignal als Spannung die in der Hochfrequenz-Spulenanordnung des MR-Gerätes induziert wird, unter dem Einfluss einer geeigneten Abfolge (Sequenz) von Hochfrequenz- und Gradientenimpulsen in der Zeitdomäne aufgezeichnet. Die eigentliche Bildrekonstruktion erfolgt dann durch Fouriertransformation der Zeitsignale. Durch die Zahl, den zeitlichen Abstand, die Dauer und die Stärke der verwendeten Gradientenpulse ist die Abtastung des reziproken k-Raumes vorgegeben, durch welchen der abzubildende Volumenbereich (FOV, "field of view") sowie die Bildauflösung bestimmt sind. Durch Anforderungen an die Bildgröße und Bildauflösung wird die Zahl der Phasenkodierungsschritte und damit die Dauer der Bildgebungssequenz vorgegeben. Bei modernen MR-Geräten wird eine Bilderzeugung mit möglichst hoher Qualität in möglichst kurzer Zeit angestrebt. Dadurch ergeben sich besondere Anforderungen an das Gradienten - und das Hochfrequenzsystem der MR-Geräte.

Bei herkömmlichen MR-Geräten werden das statische Magnetfeld, die Hochfrequenzfelder und die Magnetfeldgradienten von im wesentlichen zylindrischen Spulen erzeugt, die den zu untersuchenden Patienten vollständig umgeben. Auch zur Detektion der MR-Signale werden meist zylindrische Spulenanordnungen verwendet. Zum Hochfrequenzsystem üblicher MR-Geräte gehört eine Sende- und Empfangsspule, wie zum Beispiel eine integrierte Körperspule (body coil), die für die Volumenbildgebung des Untersuchungsvolumens nutzbar ist. Bei den sowohl zur Anregung als auch zur Detektion von MR-Signalen verwendeten Körperspulen handelt es sich üblicherweise um sogenannte Käfig-Resonatoren (birdcage coils). Diese bestehen aus einer Mehrzahl von um das Untersuchungsvolumen herum angeordneten und parallel zur Hauptfeldrichtung verlaufenden Leiterstäben, welche an den Stirnseiten der Spule über Ringleiter miteinander verbunden sind. Das Resonanzverhalten der Körperspule wird durch Kondensatorelemente bestimmt, durch welche die Leiterelemente zu einem Netzwerk verschaltet sind.

In herkömmlichen MR-System ist das statische Magnetfeld normalerweise horizontal ausgerichtet und verläuft parallel zur Längsachse der zylindrischen Spulenanordnung. Die zylindrische Konfiguration ermöglichst es zwar, hohe Feldstärken mit gut steuerbarer Feldverteilung zu generieren. Der Nachteil ist allerdings, dass der Zugang zum Untersuchungsvolumen mit dem darin befindlichen Patienten stark eingeschränkt ist. Durch die zylindrische Geometrie werden interventionelle Untersuchungen wegen der schlechten Zugänglichkeit des Patienten stark erschwert oder sogar unmöglich gemacht. Die Enge der geschlossenen zylindrischen Röhre des MR-Gerätes löst außerdem nicht selten beim Patienten klaustrophobische Reaktionen aus.

Aus den genannten Gründen wurden in der letzten Zeit sogenannte offene MR-Geräte entwickelt, bei denen das Untersuchungsvolumen sowohl für den Patienten als auch für einen untersuchenden Arzt offen und gut zugänglich ist. Einige der offenen MR-Geräte nutzen zwei scheibenförmige Magnetelemente, die auf gegenüberliegenden Seiten des Untersuchungsvolumens angeordnet sind und ein vertikal ausgerichtetes, statisches Magnetfeld erzeugen. In diesen Systemen sind die Spulen zur Erzeugung der Magnetfeldgradienten und die Hochfrequenzspulen üblicheiwase ebenfalls flach und scheibenförmig ausgebildet und in die Polflächen des Hauptfeldmagneten integriert.

Die flache Ausbildung der Hochfrequenz-Spulenanordnung bei offenen MR-Geräten hat wiederum den Nachteil, dass es schwierig ist, ein ausreichend homogenes Hochfrequenzfeld im Untersuchungsvolumen zu erzeugen. Besonders starke Inhomogenitäten ergeben sich in der Nähe der Polflächen, in welche die Leiterelemente der Hochfrequenzspulen integriert sind. Entsprechendes gilt für die Empfindlichkeit bei der Detektion der MR-Signale, die nachteiligerweise bei den offenen Systemen ebenfalls stark vom Abstand zu den Polflächen des Magneten abhängt. Ein weiteres Problem besteht darin, dass bei offenen MR-Geräten, anders als bei den herkömmlichen Systemen, seitlich um das Untersuchungsvolumen herum keine Hochfrequenz-Abschirmung vorhanden ist. Aus diesem Grund fällt die Hochfrequenzfeldstärke außerhalb des Untersuchungsvolumens nur langsam ab und auch das räumliche Empfindlichkeitsprofil bei der Detektion erstreckt sich in Bereiche weit außerhalb des Untersuchungsvolumens. Daraus ergibt sich, dass außerhalb des interessierenden Raumbereiches MR-Signale erzeugt werden, die aufgrund von Rückfaltungseffekten (aliasing) unerwünschterweise als Artefakte im gewählten FOV des erzeugten Bildes sichtbar werden.

Des weiteren sind flache Hochfrequenzspulen bei offenen MR-Geräten wesentlich ineffektiver bei der Erzeugung von Hochfrequenzfeldern als zylindrische Spulen. Aus diesem Grund erfordern offene Systeme eine wesentlich höhere Sendeleistung als die herkömmlichen geschlossenen Systeme. Abgesehen davon, dass stärkere und damit teurere Leistungsverstärker benötigt werden, liegt auch das Niveau der spezifischen Belastung des zu untersuchenden Patienten mit Hochfrequenzstrahlung erheblich über demjenigen bei herkömmlichen MR-Geräten. Weil die Leiterelemente der Spulenanordnung im Bereich der Polflächen des Magneten in großer Nähe zum Körper des Patienten angeordnet sind, kann es aufgrund der hohen Hochfrequenzfeldstärken zu gefährlichen Verletzungen (Verbrennungen) durch die Absorption der Feldenergie im Körpergewebe kommen. Um derartige Gefährdungen zu vermeiden, muss die Sendeleistung bei offenen MR-Systemen beschränkt werden. Allerdings wird hierdurch nachteiligerweise die Qualität bei der Bildgebung herabgesetzt.

Als Alternative zu den in die Polflächen des Hauptfeldmagneten integrierten Hochfrequenzspulen bietet sich die Verwendung von Oberflächenspulen oder Anordnungsn von mehreren Oberflächenspulen an, wie dies beispielsweise aus der WO 99/27381 bekannt ist. Gemäß dieser Druckschrift können mehrere, insbesondere im Bereich der Extremitäten des zu untersuchenden Patienten angeordnete Oberflächenspulen parallel betrieben werden, um damit die jeweils detektierten MR-Signale zu einem Gesamtbild zu kombinieren. Vorteilhaft ist dabei insbesondere, dass sich durch den beschränkten räumlichen Empfindlichkeitsbereich der Oberflächenspulen ein großer Rauschabstand ergibt. Die Kombination von mehreren Oberflächenspulen zur Bildgebung ist auch unter der Bezeichnung SYNERGY bekannt geworden.

Trotzdem sind die vorbekannten Anordnungen von Oberflächenspulen nicht ohne weiteres bei offenen MR-Geräten verwendbar. Zum einen ist zu beachten, dass die Orientierung der Oberflächenspulen relativ zum statischen Magnetfeld entscheidend die Empfindlichkeit bei der Detektion beeinflusst. Wie oben gesagt ist bei offenen MR-Systemen das statische Magnetfeld vertikal ausgerichtet. In diesem Fall haben flach auf oder unter dem Patienten liegende Oberflächenspulen nur eine minimale Empfindlichkeit, da durch die senkrecht zum statischen Magnetfeld präzedierende Kernmagnetisierung in einer solchen Spulenanordnung praktisch keine Spannung induziert wird In Frage kommen allenfalls seitlich des Patienten angeordnete Oberflächenspulen mit jeweils vertikal ausgerichteter Spulenebene. Hierbei ist allerdings nachteilig, dass die Empfindlichkeit von Oberflächenspulen von der Spulenebene ausgehend in das zu untersuchende Volumen hinein stark abnimmt. Die hohe Empfindlichkeit im Spuleninneren wird nicht genutzt.

Ebenfalls kommen Käfig-Resonatoren (birdcage coils), die um den Patienten herum angeordnet werden, für offene MR-Geräte nicht in Frage. Diese erzeugen nämlich ein zirkular polarisiertes Hochfrequenzfeld in einer vertikalen Ebene. Benötigt wird aufgrund des vertikal ausgerichteten statischen Magnetfeldes allerdings ein senkrecht dazu, horizontal ausgerichtetes Hochfrequenzfeld.

Davon ausgehend liegt der vorliegenden Erfindung die Aufgabe zugrunde, eine Hochfrequenz-Spulenanordnung für offene MR-Geräte bereitzustellen, bei denen das im Sendebetrieb erzeugte Hochfrequenzfeld und ebenso das räumliche Empfindlichkeitsprofil bei der Detektion möglichst eng auf das interessierende Untersuchungsvolumen beschränkt sind. Dabei soll eine hohe Empfindlichkeit bei der Detektion gegeben sein und es soll insbesondere möglich sein, für die Anforderungen der Bildgebung ausreichende Hochfrequenz-Feldstärken bei vertretbarer Belastung für den Patienten zu erzeugen.

Diese Aufgabenstellung wird bei einer Hochfrequenz-Spulenanordnung der eingangs genannten Art dadurch gelöst, dass wenigstens eines der Resonatorelemente ein Solenoidelement ist, dessen Leiterelement wenigstens eine um den Patienten herum geführte, offene Windung bildet.

Dadurch dass gemäß der Erfindung eines oder mehrere der Resonatorelemente als um den Patienten herum geführte Windungen ausgebildet sind, ergeben sich eine Reihe von Vorteilen. Zum einen wird durch derartige Solenoidelemente ein horizontal ausgerichtetes, linear polarisiertes Hochfrequenzfeld erzeugt, das wegen des vertikalen Verlaufs des Hauptfeldes gut zur Anregung von MR-Signalen im Untersuchungsvolumen eines offenen MR-Systems geeignet ist. Dementsprechend ist auch eine gute Empfindlichkeit bei der Detektion gegeben. Denkbar ist es auch, mehrere um den Patienten herum geführte Solenoidelemente relativ zueinander angewinkelt anzuordnen, so dass ein Quadraturbetrieb möglich wird Vorteilhaft ist zum anderen, dass der Patient bei der erfindungsgemäßen Anordnung im Inneren der Solenoidelemente liegt, wo das Hochfrequenzfeld bzw. das Empfindlichkeitsprofil weitgehend homogen ist.

Im Gegensatz zu den in die Polflächen des Magneten integrierten, flachen Hochfrequenzspulen haben die Solenoidelemente ein räumliches Empfindlichkeitsprofil, das mehr oder weniger eng auf den Bereich des zu untersuchenden Patienten beschränkt ist. Wenn die Windungen der Solenoidelemente eng um den Patienten herum geführt werden, wirkt sich dies positiv auf den Rauschabstand aus. Außerdem werden nur vergleichsweise niedrige Sendeleistungen zur Anregung von MR-Signalen benötigt.

Es ist vorteilhafterweise möglich, den einzelnen Resonatorelementen der erfindungsgemäßen Spulenanordnung separate Empfangskanäle zuzuordnen, über welche die detektierten MR-Signale an eine Empfangseinheit zur Weiterverarbeitung übertragen werden. Es besteht damit einerseits die Möglichkeit, durch Kombination der mittels der einzelnen Resonatorelemente detektierten MR-Signale eine Volumenbildgebung mit möglichst großem FOV durchzuführen. Alternativ können aus den getrennt detektierten MR-Signalen Teilbilder erzeugt werden, die dann nachträglich zu einem Gesamtbild miteinander kombiniert werden. Dies kann einerseits zur Verbesserung des Rauschabstandes vorteilhaft sein, wobei die einzelnen Resonatorelemente als Synergie-Spulen eingesetzt werden. Auch besteht die Möglichkeit, die Einzelbilder unter Zugrundelegung der den einzelnen Resonatorelementen zugeordneten räumlichen Empfindlichkeitsprofile miteinander zu kombinieren, um bei der Bildgebung Messzeit einzusparen (SENSE-Methode, sensitivity encoding). Vorteilhaft ist, dass dabei die wohldefinierten räumlichen Empfindlichkeitsprofile der Solenoidelemente ausgenutzt werden können.

Zweckmäßig ist es, bei der Hochfrequenz-Spulenanordnung nach der Erfindung die Ebene wenigstens eines Solenoidelementes gemäß Anspruch 2 senkrecht zur Längsachse des Patienten auszurichten. Auf diese Weise ist es möglich, die Windungen der betreffenden Solenoidelemente möglichst eng um den Patienten herum zu führen, um so eine maximale Empfindlichkeit und einen optimalen Rauschabstand zu erhalten. Insbesondere kann auf diese Weise eine vorteilhafte Ausführungsform der Spulenanordnung gemäß Anspruch 3 realisiert werden, bei der eine Mehrzahl von Solenoidelementen mit variablem Windungsumfang axial hintereinander angeordnet sind. Durch ein paralleles Bildgebungsverfahren kann ein großes FOV abgsdeckt werden, indem die betreffenden interessierenden Regionen des Patienten von einzelnen Solenoidelementen umschlossen werden. Der Windungsumfang wird an den Umfang des Patienten angepasst, indem jede Windung eng um den Patienten herum geführt wird Auf diese Weise wird der empfindliche Bereich eng auf die interessierenden Regionen beschränkt, was sich vorteilhaft auf die Bildqualität auswirkt.

Eine vorteilhafte Weiterbildung der erfindungsgemäßen Spulenanordnung ergibt sich gemäß Anspruch 4 dadurch, dass wenigstens eines der Resonatorelemente eine Oberflächenspule ist, die derart ausgerichtet ist, dass das von der Oberflächenspule erzeugte hochfrequente Magnetfeld eine zur Längsachse des Patienten senkrechte Komponente aufweist. Durch die Kombination von um den Patienten herum geführten Solenoidelementen mit zusätzlichen Oberflächenspulen kann eine weiter verbesserte Empfangsqualität (verbesserter Rauschabstand, höhere Auflösung) erzielt werden. Aus den oben beschriebenen Gründen muss die Oberflächenspule bei einem offenen MR-Gerät für eine optimale Empfindlichkeit derart ausgerichtet sein, dass durch die in der horizontalen Ebene präzedierende Kernmagnetisierung eine detektierbare Spannung induziert wird Insbesondere wenn die Ebene der verwendeten Oberflächenspule senkrecht zu den Solenoidelementen ausgerichtet wird, unterscheiden sich die räumlichen Empfindlichkeitsprofile der betreffenden Resonatorelemente stark voneinander, was vorteilhaft bei der Bildrekonstruktion mittels der SENSE-Methode ist. Denkbar ist es beispielsweise, Oberflächenspulen zusammen mit Solenoidelementen auf einem gemeinsamen, den Patienten umgebenden Zylindermantel anzuordnen. Die Oberflächenspulen werden dann je nach Lage zum Hauptmagnetfeld als Ringspulen oder als sogenannte Butterfly-Spulen ausgebildet. Es lassen sich somit Spulenanordnungen realisieren, die optimal sowohl für die Kopf-, die Körper- oder insbesondere die Kopf/Hals-Bildgebung geeignet sind.

Für parallele Bildgsbungsverfahren sollten die einzelnen Resonatorelemente der erfindungsgemäßen Hochfrequenz-Spulenanordnung voneinander enthoppelt sein. Dies kann besonders einfach gemäß Anspruch 5 mittels zwischen den Leiterelementen angeordneter Kapazitäten oder Induktivitäten erfolgen. Durch geeignete Bemessung der Kapazitäts- beziehungsweise Induktivitätswerte muss sichergestellt werden, dass keine resonante Kopplung zwischen den unterschiedlichen Resonatorelementen besteht. Es kann dabei sinnvoll sein, Entkopplungsnetzwerke (bestehend aus Kapazitäten und Induktivitäten) zwischen den Leiterelementen sowohl benachbarter als auch entfernterer Resonatorelemente vorzusehen.

Die erfindungsgemäße Spulenanordnung kann bei einem offenen MR-Gerät gemäß den Ansprüchen 6 und 7 zum Einsatz kommen. Dabei ist zur Durchführung von parallelen Bildgebungsverfahren (SYNERGY, SENSE) zweckmäßigerweise jedem Resonatorelement ein separater Empfangskanal der Empfangseinheit zugeordnet ist.

Eine vorteilhafte Weiterbildung eines solchen MR-Gerätes ergibt sich gemäß Anspruch 8 dadurch, dass jedem Resonatorelement ein separater Sendekanal einer Sendeeinheit zugeordnet ist, wobei mittels der Sendeeinheit für jedes Resonatorelement die Phase und/oder die Amplitude der Hochfrequenz-Einspeisung individuell vorgebbar sind.

Dadurch dass bei dem erfindungsgemäßen offenen MR-Gerät jedem Resonatorelement ein separater Sendekanal zugeordnet ist, ist die Feldverteilung im Untersuchungsvolumen vorteilhafterweise vollständig kontrollierbar. Es ist nämlich möglich, jede erdenkliche Stromverteilung in der Anordnung der Leiterelemente durch Vorgabe von Amplitude und Phase auf den einzelnen Sendekanälen zu erzeugen. Auch der zeitliche Verlauf der Hochfrequenz-Einspeisung kann auf jedem Sendekanal individuell unterschiedlich vorgegeben werden. Die Amplitude und die Phase jedes einzelnen Sendekanals können durch die Software des MR-Gerätes kontrolliert werden, was eine direkte interaktive Steuerung der Feldverteilung (RF-Shimming) möglich macht. Denkbar ist es beispielsweise, eine vollautomatische Regelung der Hochfrequenz-Feldhomogenität im Untersuchungsvolumen in die Bildgebungssequenz zu integrieren, um veränderliche Einflüsse auf die Feldverteilung, wie beispielsweise durch die unterschiedlichen dielektrischen Eigenschaften der untersuchten Patienten, zu kompensieren.

Durch die Möglichkeit, die räumliche Verteilung des Hochfrequenzfeldes im Untersuchungsvolumen beliebig vorgeben zu können, erschließen sich eine Reihe von weiteren Anwendungsfeldern. So lassen sich beispielsweise Gradienten im Hochfrequenzfeld in verschiedenen Raumrichtungen erzeugen. Durch die Vorgabe von räumlich und zeitlich variablen Hochfrequenz-Feldmustern kann der angeregten Kernmagnetisierungsverteilung eine Ortscodierung aufgsprägt werden, die für eine schnelle Volumenbildgebung nutzbar ist (Transmit-SENSE-Methode). Denkbar ist außerdem eine räumlich selektive Vorsättigung der Kernmagnetisierung im Untersuchungsvolumen.

Eine besonders einfach Realisierung ergibt sich gemäß Anspruch 9, wonach nämlich jeder Sendekanal an einen dem betreffenden Resonatorelement zugeordneten Ausgang eines Verbindungsnetzwerkes (Combiner-Hybrid) angeschlossen ist, durch welches die Leistung eines Sendeverstärkers auf die einzelnen Resonatorelemente verteilt wird. Dabei wird durch das Verbindungsnetzwerk für jedes Resonatorelement die Phase und die Amplitude des jeweils eingespeisten Hochfrequenzsignals festgelegt. Diese Ausführung hat den Vorteil, dass lediglich ein einziger Leistungssender für die Hochfrequenzeinstrahlung benötigt wird, dessen Ausgangssignal mittels des Combiner-Hybrids auf die einzelnen Resonatorelemente verteilt wird. Dabei erfolgt die Verteilung zweckmäßigerweise derart, dass im Untersuchungsvolumen eine möglichst homogene Hochfrequenz-Feldverteilung erzeugt wird.

Ausführungsbeispiele der Erfindung werden im folgenden anhand der Figuren erläutert. Es zeigen:
- Fig.1: MR-Gerät mit erfindungsgemäßer Hochfrequenz-Spulenanordnung
- Fig.2: erfindungsgemäße Spulenanordnung für die Kopf/Hals-Bildgebung;
- Fig.3: alternative Ausführungsform einer Kopf/Hals-Spulenanordnung.

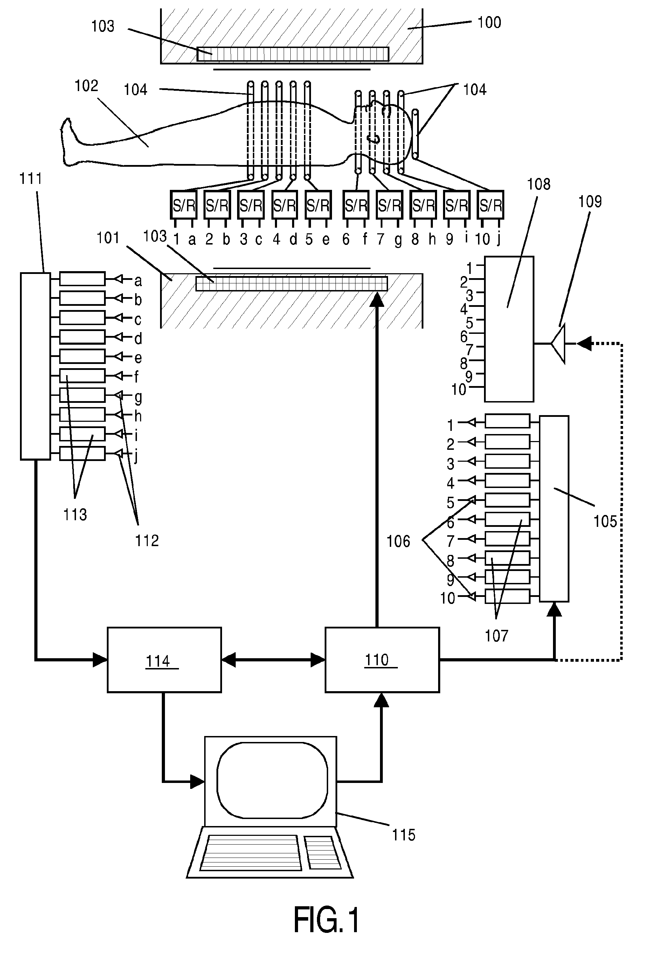

Im Zentrum des in der Figur 1 dargestellten MR-Gerätes steht ein offener Magnet mit einer oberen Polscheibe 100 und einer unteren Polscheibe 101. Zwischen den beiden Polscheiben 100,101 befindet sich das Untersuchungsvolumen, in dem sich auf einemnicht näher dargestellten Patiententisch ein Patient 102 befindet. Im Bereich des Untersuchungsvolumens wird ein vertikal gerichtetes, statisches Magnetfeld mit einer Stärke von beispielsweise 0.7 Tesla erzeugt. Für die MR-Bildgebung müssen im Untersuchungsvolumen außerdem zeitlich veränderliche Magnetfeldgradienten erzeugt werden. Hierzu dienen mehrere Gradientenspulen 103, die in die Polscheiben 100, 101 des offenen Magneten integriert sind. Die für die MR-Bildgebung ferner erforderliche Erzeugung von Hochfrequenzfeldern erfolgt mittels einer Anordnung von Hochfrequenzspulen, die gemäß der Erfindung aus zehn Solenoidelementen 104 besteht, deren Leiterelemente jeweils um den Patienten herum geführte, offene Windungen bilden. In die Solenoidelemente 104 sind nicht näher dargestellte Kondensatoren integriert, wodurch das Resonanzverhalten der Anordnung bestimmt wird. In der Figur 1 sind zwei Gruppen von Solenoidelementen dargestellt. Um den Brustkorb des Patienten 102 sind fünf Windungen mit einem entsprechend großen Umfang geführt. Die um den Kopf des Patienten geführten Windungen sind entsprechend dem geringeren Umfang des Kopfes kleiner. Im Bereich der Schädeldecke des Patienten 102 kommt eine besonders kleine Windung zum Einsatz Außer zur Anregung von MR-Signalen im Untersuchungsvolumen wird die dargestellte Spulenanordnung auch zu deren Detektion verwendet. Jedes der in der Figur 1 dargestellten zehn Solenoidelemente 104 steht mit einem Umschalter S/R in Verbindung durch den das betreffende Resonatorelement 104 je nach Betriebsmodus mit einem von zwei möglichen Anschlüssen verbunden wird. Die für den Sendebetrieb bestimmten Anschlüsse sind mit den Ziffern 1-10, die für den Empfangsbetrieb vorgssehenen Anschlüsse mit den Kleinbuchstaben a-j bezeichnet. Den Anschlüssen 1-10 sind die mit den entsprechenden Ziffern versehenen Ausgänge einer Sendeeinheit 105 zugeordnet. Diese hat für jedes einzelne Resonatorelement der Spulenanordnung einen eigenen Sendekanal, welcher jeweils einen Leistungsverstärker 106 sowie eine Hochfrequenz-Steuereinheit 107 aufweist. Mittels der Hochfrequenz-Steuereinheiten 107 ist die Amplitude und die Phase des Hochfrequenzsignals für jeden einzelnen Sendekanal individuell einstellbar, so dass nahezu jede beliebige Hochfrequenz-Feldverteilung im Untersuchungsvolumen des MR-Gerätes erzeugt werden kann. Als weniger aufwendige Alternative ist es auch möglich, ein Verteilungsnetzwerk 108 (Combiner-Hybrid) zu verwenden, durch welches das Ausgangssignal eines Hochfrequenz-Sendeverstärkers 109 auf die Anschlüsse 1-10 verteilt wird, wobei, durch das Combiner-Hybrid 108 für jeden Ausgangskanal 1-10 die Amplitude und Phase des Hochfrequenzsignals festgelegt wird. Zur Erzeugung von Hochfrequenzpulsen im Untersuchungsvolumen steht die Sendeeinheit 105 beziehungsweise der Sendeverstärker 109 mit einer Steuerungseinheit 110 in Verbindung. Zur Kontrolle der zeitlichen Abfolge der Gradientenpulse ist die Steuerungseinheit 110 außerdem mit der Gradienten-Spulenanordnung 103 verbunden. Den für den Empfangsbetrieb bestimmten Anschlüssen a-j sind mit den entsprechenden Buchstaben bezeichnete Empfangskanäle einer Empfangseinheit 111 zugeordnet. Jeder Empfangskanal ist mit einem empfindlichen Hochfrequenz-Vorverstärker 112 sowie mit einem Demodulator 113 ausgestattet. Die von der Empfangseinheit 111 registrierten MR-Signale werden an eine Rekonstruktionseinheit 114 übertragen, wo die digitalisierten Signale miteinander kombiniert und Fourier-analysiert werden. Die mittels der Rekonstruktionseinheit 114 generierten Bilder werden dann auf dem Monitor eines Mikrocomputers 115 ausgegeben. Der Mikrocomputer 115 dient gleichzeitig der Steuerung des MR-Gerätes durch einen Benutzer, wozu der Computer 115 außerdem mit der Steuerungseinheit 110 in Verbindung steht.

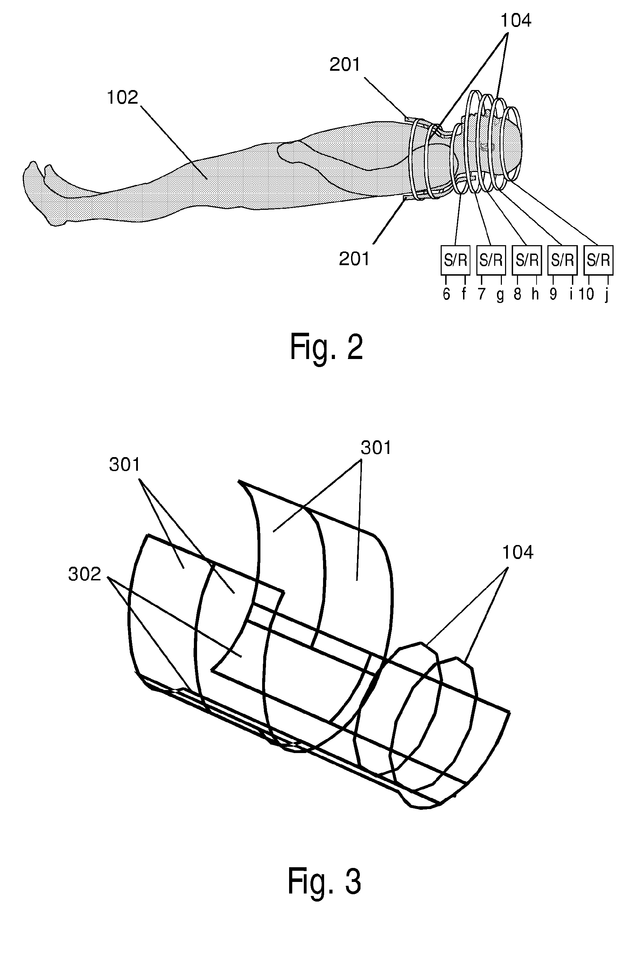

Die Figur 2 zeigt eine für die Kopf/Hals-Bildgebung optimierte Anordnung von um den Patienten 102 herum geführten Solenoidelementen 104. Der Umfang der Windungen 104 ist jeweils an den Umfang des Kopfes, des Halses und der Schultern des Patienten angepasst, um das empfindliche Volumen der Anordnung möglichst eng auf die interessierenden Regionen des zu untersuchenden Patienten 102 zu beschränken. Die Windungen werden durch eine Halterungsvorrichtung 201 am Körper des Patienten 102 abgestützt. Dadurch dass die einzelnen Solenoidelemente 104 mit separaten Empfangskanälen f-j verbunden sind, kann durch Kombination der jeweils detektierten MR-Signale eine vollständige Volumen-Bildgebung des Kopf-Hals-Schulterbereiches durchgeführt werden.

Die Figur 3 zeigt eine alternative Spulenanordnung für die Kopf/Hals-Bildgebung. Diese besteht neben den um den Hals des hier nicht dargestellten Patienten herum geführten Solenoidelementen 104 aus seitlich am Kopf angeordneten Oberflächenspulen 301, welche ein Hochfrequenzfeld erzeugen, das horizontal ausgerichtete Komponenten hat, die also senkrecht zum Hauptfeld des offenen MR-Gerätes verlaufen. Im Nackenbereich weist die dargestellte Spulenanordnung Oberflächenspulen 302 auf, die als Butterfly-Spulen zusammengeschaltet sind, und somit zusammenwirkend ebenfalls ein im wesentlichen horizontal gerichtetes Feld erzeugen. Die gezeigte Spulenanordnung ist an die Anatomie des Patienten angepasst, so dass eine Bildgebung der Kopf/Hals-Region mit hoher Auflösung und hohem Rauschabstand in offenen MR-Systemen möglich ist. In der Verwendung entspricht eine solchen Anordnung den Kopfspulen bei herkömmlichen MR-Geräten, die dort in aller Regel als Käfig-Resonatoren (birdcage coils) ausgebildet sind.

## Patentansprüche

1. Hochfrequenz-Spulenanordnung, insbesondere für ein offenes MR-Gerät, mit einer Mehrzahl von Resonatorelementen, die im Bereich eines im Untersuchungsvolumen eines MR-Gerätes befindlichen Patienten (102) angeordnet werden, wobei die Resonatorelemente aus wenigstens einem Leiterelement und wenigstens einem Kondensator bestehen,
**dadurch gekennzeichnet,**
**dass** wenigstens eines der Resonatorelemente ein Solenoidelement (104) ist, dessen Leiterelement wenigstens eine um den Patienten (102) herum geführte, offene Windung bildet.

2. Hochfrequenz-Spulenanordnung nach Anspruch 1,
**dadurch gekennzeichnet,**
**dass** die Ebene wenigstens eines Solenoidelementes (104) senkrecht zur Längsachse des Patienten (102) ausgerichtet ist.

3. Hochfrequenz-Spulenanordnung nach Anspruch 1,
**gekennzeichnet durch** eine Mehrzahl von axial hintereinander angeordneten Solenoidelementen (104) mit variablem Windungsumfang, wobei der jeweilige Windungsumfang an den Umfang des zu untersuchenden Patienten (102) anpassbar ist.

4. Hochfrequenz-Spulenanordnung nach Anspruch 1,
**dadurch gekennzeichnet,**
**dass** wenigstens eines der Resonatorelemente eine Oberflächenspule ist, die derart ausgerichtet ist, dass das von der Oberflächenspule erzeugte hochfrequente Magnetfeld eine zur Längsachse des Patienten (102) senkrechte Komponente aufweist.

5. Hochfrequenz-Spulenanordnung nach Anspruch 1,
**dadurch gekennzeichnet,**
**dass** die Resonatorelemente paarweise über Entkopplungselemente miteinander verbunden sind.

6. MR-Gerät mit einem offenen Hauptfeldmagneten (100, 101), der in einem Untersuchungsvolumen ein im wesentlichen vertikal ausgerichtetes, statisches Magnetfeld erzeugt, einer Gradienten-Spulenanordnung (103), einer aus einer Mehrzahl von Resonatorelementen bestehenden Hochfrequenz-Spulenanordnung gemäß Anspruch 1, und einer mit der Hochfrequenz-Spulenanordnung in Verbindung stehenden Empfangseinheit (111),
**dadurch gekennzeichnet,**
**dass** wenigstens eines der Resonatorelemente ein Solenoidelement (104) ist, dessen Leiterelement wenigstens eine um den im Untersuchungsvolumen des Hauptfeldmagneten befindlichen Patienten (102) herum geführte, offene Windung bildet, und dass jedem Resonatorelement ein separater Empfangskanal (a-j) der Empfangseinheit (111) zugeordnet ist.

7. MR-Gerät nach Anspruch 6,
**gekennzeichnet durch** eine Mehrzahl von axial hintereinander angeordneten, senkrecht zur Längsachse des Patienten (102) ausgerichteten Solenoidelementen (104), mit zumindest teilweise unterschiedlichem Windungsumfang.

8. MR-Gerät nach Anspruch 6,
**dadurch gekennzeichnet,**
**dass** jedem Resonatorelement ein separater Sendekanal (1-10) einer Sendeeinheit (105) zugeordnet ist, wobei mittels der Sendeeinheit (105) für jedes Resonatorelement die Phase und/oder die Amplitude der Hochfrequenz-Einspeisung individuell vorgebbar sind.

9. MR-Gerät nach Anspruch 8,
**dadurch gekennzeichnet,**
**dass** die Sendeeinheit eine Netzwerkschaltung (Combiner-Hybrid, 108) aufweist, durch welche die Leistung eines Sendeverstärkers (109) auf die einzelnen Resonatorelemente verteilt wird, wobei durch die Netzwerkschaltung (108) für jedes Resonatorelement die Phase und die Amplitude des jeweils eingespeisten Hochfrequenzsignals festgelegt werden.
